# EUROPEAN PATENT SPECIFICATION

(11) **EP 2 552 124 B1**
(45) Date of publication and mention of the grant of the patent: **27.07.2016**
(21) Application number: 11789621.7
(22) Date of filing: 18.05.2011
(51) Int. Cl.: H04R 1/02, H04R 1/04, H04R 1/28, H04R 1/38, H04R 19/04, H05K 3/40

(54) **SUBSTRATE WITH ELECTRO-ACOUSTIC CONVERSION ELEMENT MOUNTED THEREON, MICROPHONE UNIT, AND MANUFACTURING METHODS THEREFOR**
SUBSTRAT MIT EINEM DARAUF MONTIERTEN ELEKTROAKUSTISCHEN WANDLERELEMENT, MIKROFONEINHEIT UND HERSTELLUNGSVERFAHREN DAFÜR
SUBSTRAT PORTANT UN ÉLÉMENT DE CONVERSION ÉLECTROACOUSTIQUE, UNITÉ DE MICROPHONE ET PROCÉDÉS POUR LEUR FABRICATION

(30) Priority: 01.06.2010 JP 2010125532
(43) Date of publication of application: 30.01.2013
(73) Proprietor: Funai Electric Co., Ltd., Daito-shi Osaka 574-0013 (JP)
(72) Inventor: UMEDA, Shuji, Daito-Shi Osaka 574-0013 (JP); HORIBE, Ryusuke, Daito-Shi Osaka 574-0013 (JP); TANAKA, Fuminori, Daito-Shi Osaka 574-0013 (JP); INODA, Takeshi, Daito-Shi Osaka 574-0013 (JP)
(74) Representative: Manitz, Finsterwald & Partner GbR
(86) International application number: PCT/JP2011/061392
(87) International publication number: WO 2011/152212

(56) References cited:
- WO-A1-2009/099168
- JP-A- 9 116 265
- JP-A- 2004 200 766
- JP-A- 2004 537 182
- JP-A- 2007 184 341
- JP-A- 2007 329 559
- US-A1- 2005 018 864
- US-A1- 2006 233 400
- US-A1- 2009 067 659

## Description

### Technical Field

The present invention relates to an electro-acoustic conversion device mount substrate that is mounted with an electro-acoustic conversion device that converts a sound signal into an electric signal and to a microphone unit that includes the electro-acoustic conversion device mount substrate. Besides, the present invention relates to a manufacturing method for the electro-acoustic conversion device mount substrate and microphone unit. The features of the preamble of the independent claims are known from US 2005/018864 A1. Related technologies are known from WO 2009/099168 A1 and US 2009/0067659 A1.

### Background Art

Conventionally, a microphone, which has a function to convert an input sound into an electric signal and output it, is applied to various types of voice input apparatuses (e.g., voice communication apparatuses such as a mobile phone, a transceiver and the like, information process apparatuses such as a voice identification system and the like that use a technology for analyzing an input voice, recording apparatuses and the like).

A microphone unit includes an electro-acoustic conversion device that converts a sound signal into an electric signal. The electro-acoustic conversion device is mounted on a substrate (electro-acoustic conversion device mount substrate) on which a wiring pattern is formed as shown in patent documents 1 and 2, for example. There is a case where an electro-acoustic conversion device, as shown in the patent document 1, is mounted on a substrate to cover an opening that connects to an intra-substrate space (which functions as a rear chamber in some cases and functions as a sound hole (sound path) in other cases) which is formed in the substrate.

Here, an "intra-substrate space" in the present specification is a space that is formed at a more inner portion with respect to a substrate outer circumferential surface (assuming that an opening surface forms the outer circumferential surface at a portion where the opening is formed) as a reference surface.

### Citation List

### Patent Literature

PLT1: JP-A-2008-510427
PLT2: JP-A-2010-41565

### Summary of Invention

### Technical Problem

In the meantime, there is a case where as an electro-acoustic conversion device included in a microphone unit, a MEMS (Micro Electro Mechanical System) chip formed by using a semiconductor manufacturing technology is used because of reasons that size reduction is possible and the like. The MEMS chip includes a diaphragm and a fixed electrode that is disposed to oppose the diaphragm with a gap therebetween and forms a capacitor together with the diaphragm.

In the MEMS chip, the gap formed between the diaphragm and the fixed electrode is, for example, 1 µm that is narrow. Because of this, if dust invades the gap, defective operation of the MEMS chip is caused.

As for a substrate such as an FR-4 substrate (glass epoxy substrate) and the like that includes a resin fiber, a fiber garbage (an example of dust) easily occurs from a surface that is scraped to form a through-hole, a groove and the like, for example. Because of this, in a microphone unit (e.g., shown in the patent document 1) having a structure which is mounted with a MEMS chip to cover an opening that connects to an intra-substrate space (which has a surface to which machining such as scraping and the like is applied), there is a problem that if a substrate such as an FR-4 substrate that easily emits dust is employed as the substrate, defective operation of the MEMS chip easily occurs.

In light of the above points, it is an object of the present invention to provide an electro-acoustic conversion device mount substrate that is able to reduce a likelihood that an electro-acoustic conversion device malfunctions because of dust. Besides, it is another object of the present invention to provide a small and high-quality microphone unit for which anti-dust measures are taken by including the electro-acoustic conversion device mount substrate. Further, it is another object of the present invention to provide a preferred method for manufacturing the electro-acoustic conversion device mount substrate and the microphone unit.

### Solution to Problem

To achieve the above objects, an electro-acoustic conversion device mount substrate according to the present invention, as defined in the independent apparatus claim, is an electro-acoustic conversion device mount substrate that is mounted with an electro-acoustic conversion device which converts a sound signal into an electric signal, the electro-acoustic conversion device mount substrate includes: a mount surface on which the electro-acoustic conversion device is mounted and which is provided with an opening that is covered by the electro-acoustic conversion device; and an intra-substrate space connected to the opening;
wherein at least a portion of a wall surface that forms the intra-substrate space is covered by a metal plated layer.

According to this structure, it is possible to obtain a state in which dust is unlikely to occur by covering a surface, to which machining such as severing, scraping and the like is applied, by means of the coating layer. Because of this, it is easy to prevent malfunction of the electro-acoustic conversion device by using the electro-acoustic conversion device mount substrate that has the present structure.

In the electro-acoustic conversion device mount substrate having the above structure, the coating layer may be a plated layer. According to this structure, it is easy to form the coating layer as well for anti-dust measures concurrently when forming, for example, a through-wiring through the electro-acoustic conversion device mount substrate, which is convenient.

Besides, in the electro-acoustic conversion device mount substrate having the above structure, a glass epoxy material may be used as a substrate material. As described above, the glass epoxy substrate easily emits dust from the surface to which the machining such as severing, scraping and the like is applied. Because of this, in the case of this structure, an effect of the anti-dust measures due to the coating process becomes great.

Besides, in the electro-acoustic conversion device mount substrate having the above structure, the intra-substrate space may not connect to another opening other than the opening, or may connect to the another opening other than the opening. Further, in a case where the intra-substrate space connects to the another opening other than the opening, the another opening may be disposed through a rear surface opposite to the mount surface, or may be disposed through the mount surface. A microphone unit is produced into various forms depending on the purpose, and the electro-acoustic conversion device mount substrate according to the present invention is widely applicable to the various forms.

To achieve the above objects, a microphone unit according to the present invention includes: an electro-acoustic conversion device mount substrate having a structure according to the corresponding independent apparatus claim; an electro-acoustic conversion device that is mounted on the mount surface to cover the opening; and a cover portion that collaborates with the electro-acoustic conversion device mount substrate to form a housing space for housing the electro-acoustic conversion device.

The microphone unit having the above structure is unlikely to emit dust in the intra-substrate space, accordingly, malfunction of the electro-acoustic conversion device is unlikely to occur. In other words, according to this structure, it is possible to provide the microphone unit that has a high quality.

In the microphone unit having the above structure, the electro-acoustic conversion device may be a MEMS chip that includes: a diaphragm and a fixed electrode that is disposed to oppose the diaphragm with a gap therebetween and forms a capacitor together with the diaphragm. It is possible to form the MEMS chip to be small, because of this, according to this structure, it is possible to provide the microphone unit that is small and has a high quality.

To achieve the above objects, a method for manufacturing the electro-acoustic conversion device mount substrate according to the present invention, as defined in the independent method claim, includes: a first step for preparing a substrate that is provided with an opening formed through a mount surface of the substrate and covered by the electro-acoustic conversion device, an intra-substrate space connected to the opening; a second step for applying a metal plating process to a wall surface that forms the intra-substrate space; and a third step for forming a wiring pattern on a substrate outer surface by performing an etching process after the plating process.

According to this structure, concurrently with the forming of the through-wiring, it is possible to cover, by means of the plated layer (a form of the coating layer), a wall surface of the intra-substrate space that connects to the opening covered by the electro-acoustic conversion device, whereby it is easy to perform the forming of the electro-acoustic conversion device mount substrate to which the anti-dust measures are applied.

The method for manufacturing the electro-acoustic conversion device mount substrate having the above structure may further include: a fourth step for attaching another substrate to a rear surface opposite to a surface of the substrate, on which the wiring pattern is formed in the third process, through which the opening is formed; a fifth step for mounting a protection cover to cover an entire surface of the substrate, on which the wiring pattern is formed in the third process, through which the opening is formed; a sixth step for forming a through-hole for a through-wiring through the another substrate; a seventh step for applying a plating process to the through-hole for the through-wiring that is formed in the sixth step after completion of the fourth step, the fifth step and the sixth step that are performed in random order; an eighth step for forming a wiring pattern on the another substrate by means of an etching process after the seventh step is completed; and a ninth step for separating the protection cover after the wiring pattern is formed on the another substrate.

For example, in a case where it is impossible to form the intra-substrate space by only digging in a substrate thickness direction, there is a case where it is convenient to form the electro-acoustic conversion device mount substrate by using a plurality of substrates. This structure envisions the case where the electro-acoustic conversion device mount substrate having the intra-substrate space is formed by using a plurality of substrates. And, in the case where the electro-acoustic conversion device mount substrate is formed by using a plurality of substrates, there is a worry, over that a plating process liquid, an etching process liquid and the like invade the intra-substrate space, residues of them remain to the end and a contaminated electro-acoustic conversion device mount substrate is produced. In this point, according to this structure, in expectation of a likelihood that the plating liquid and the like remain in the intra-substrate space in the later steps, the protection cover is mounted beforehand to cover the intra-substrate space, thereafter, the plating process and the etching process are performed. Because of this, it is possible to reduce the likelihood of providing the above contaminated electro-acoustic conversion device mount substrate.

To achieve the above objects, a method for manufacturing a microphone unit according to the present invention includes: a step for manufacturing an electro-acoustic conversion device mount substrate by means of the manufacturing method having the above structure; a step for mounting the electro-acoustic conversion device onto the electro-acoustic conversion device mount substrate to cover the opening; and a step for covering a cover portion onto the electro-acoustic conversion device mount substrate to cover the electro-acoustic conversion device.

According to this structure, the electro-acoustic conversion device mount substrate to which the anti-dust measures are applied and which has a low contamination likelihood is manufactured and the microphone unit is assembled by using the electro-acoustic conversion device mount substrate, accordingly, it is possible to provide the microphone unit that has a high quality.

### Advantageous Effects of Invention

According to the present invention, it is possible to provide an electro-acoustic conversion device mount substrate that is able to reduce a likelihood that an electro-acoustic conversion device malfunctions due to dust. Besides, according to the present invention, by including the electro-acoustic conversion device mount substrate, it is possible to provide a small and high-quality microphone to which anti-dust measures are applied. Further, according to the present invention, it is possible to provide a preferred manufacturing method for the electro-acoustic conversion device mount substrate and the microphone unit.

### Brief Description of Drawings

[Fig. 1] is a schematic sectional view showing a structure of a microphone unit according to a first embodiment to which the present invention is applied.
[Fig. 2] is a schematic sectional view showing a structure of a MEMS chip which the microphone unit according to the first embodiment includes.
[Fig. 3] is a sectional view for describing a manufacturing method for a mike substrate which the microphone unit according to the first embodiment includes.
[Fig. 4] is a schematic sectional view showing a structure of a microphone unit according to a second embodiment to which the present invention is applied.
[Fig. 5] is a sectional view for describing a manufacturing method for a mike substrate which the microphone unit according to the second embodiment includes.
[Fig. 6] is a schematic sectional view showing a structure of a microphone unit according to a third embodiment to which the present invention is applied.
[Fig. 7] is a sectional view for describing a manufacturing method for a mike substrate which the microphone unit according to the third embodiment includes.
[Fig. 8] is a schematic sectional view showing a structure of a microphone unit according to a fourth embodiment to which the present invention is applied.
[Fig. 9] is a sectional view for describing a manufacturing method for a mike substrate which the microphone unit according to the fourth embodiment includes. Description of Embodiments

Hereinafter, an electro-acoustic conversion device mount substrate, a microphone unit, and manufacturing methods of them are described in detail with reference to the drawings.

### (First Embodiment)

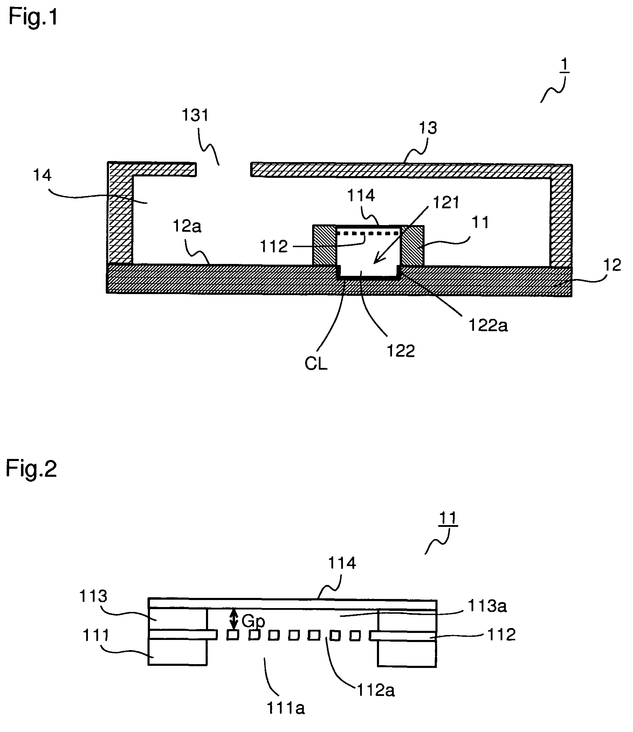

Fig. 1 is a schematic sectional view showing a structure of a microphone unit according to a first embodiment to which the present invention is applied. As shown in Fig. 1, a microphone unit 1 according to the first embodiment includes: a MEMS chip 11; a mike substrate 12 on which the MEMS chip 11 is mounted; and a cover 13. The microphone unit 1 according to the first embodiment functions as an omnidirectional mike.

The MEMS chip 11 including a silicon chip is an embodiment of the electro-acoustic conversion device according to the present invention, and a small capacitor type microphone unit that is manufactured by using a semiconductor manufacturing technology. Fig. 2 is a schematic sectional view showing a structure of the MEMS chip which the microphone unit according to the first embodiment includes. The MEMS chip 11 has a substantially rectangular parallelepiped shape in outer shape, and as shown in Fig. 2, includes: an insulating base substrate 111; a fixed electrode 112; an insulating intermediate substrate 113; and a diaphragm 114.

The base substrate 111 is provided with a through-hole 111a having a substantially circular shape when viewed from top through its central portion. The plate-shaped fixed electrode 112 is disposed on the base substrate 111 and provided with a plurality of small-diameter (about 10 µm in diameter) through-holes 112a. The intermediate substrate 113 is disposed on the fixed electrode 112 and, like the base substrate 111, is provided with a through-hole 113a having a substantially circular shape when viewed from top through its central portion. The diaphragm 114 disposed on the intermediate substrate 113 is a thin film which receives a sound pressure to vibrate (vibrate vertically in Fig. 2. Besides, in the present embodiment, the substantially circular portion vibrates.), has electrical conductivity and forms an end of the electrode. The fixed electrode 112 and the diaphragm 114, which are disposed to be in a substantially parallel relationship with each other across a gap Gp thanks to the presence of the intermediate substrate 113, form a capacitor.

In the MEMS chip 11, when a sound wave reaches and the diaphragm 114 vibrates, an inter-electrode distance between the diaphragm 114 and the fixed electrode 112 changes, accordingly, electrostatic capacity changes. As a result of this, it is possible to fetch the sound wave (sound signal) entering the MEMS chip 11 as an electric signal. Here, in the MEMS chip 11, thanks to the presence of the through-hole 111a formed through the base substrate 111, the plurality of through-holes 112a formed through the fixed electrode 112 and the through-hole 113a formed through the intermediate substrate 113, a lower surface of the diaphragm 114 also is able to communicate with an outside space (outside the MEMS chip 11).

The mike substrate 12, which is formed to have a substantially rectangular shape when viewed from top, is an embodiment of the electro-acoustic conversion device mount substrate according to the present invention, and on an upper surface 12a of which the MEMS chip 11 is mounted. Although skipped in Fig. 1, the mike substrate 12 is provided with a wiring pattern (inclusive of a through-wiring) that is necessary to apply a voltage to the MEMS chip 11 and to fetch an electric signal from the MEMS chip 11.

Besides, the mike substrate 12 is provided with an opening 121 through the mount surface (upper surface) 12a on which the MEMS chip 11 is mounted, and the MEMS chip 11 is disposed to cover the opening 121. The opening 121 connects to an intra-substrate space 122 that has a substantially cylindrical shape. The intra-substrate space 122 connects to only the opening 121 but does not connect to another opening. In other words, the mike substrate 12 is provided with a recess by means of the opening 121 and the intra-substrate space 122. The intra-substrate space 122 is disposed with intention of increasing a volume of a rear chamber (a tightly closed space that faces a lower surface of the diaphragm 114). If the rear chamber volume increases, the diaphragm 114 is easily displaced, and the mike sensitivity of the MEMS chip 11 improves.

Here, the mike substrate 12 may be, for example, an FR-4 (glass epoxy substrate) substrate, however, may be another kind of substrate.

The cover 13, which is formed to have a substantially rectangular-parallelepiped shape in outer shape, is placed over the mike substrate 12, thereby collaborating with the mike substrate 12 to form a housing space 14 that houses the MEMS chip 11. The cover 13 is provided with a sound hole 131 that guides a sound occurring outside the microphone unit 1 to the diaphragm 114 of the MEMS chip 11. Here, the cover 13 is an embodiment of a cover portion of the present invention.

When a sound wave input into the housing space 14 via the sound hole 131 reaches the diaphragm 114, the diaphragm 114 vibrates, whereby as described above, a change in the electrostatic capacity occurs. The microphone unit 1 is structured to fetch the change in the electrostatic capacity as an electric signal and outputs it to outside. Here, it is preferable that an electric circuit portion for fetching the change in the electrostatic capacity as the electric signal is disposed in the housing space 14; however, may be disposed outside the housing space 14. Besides, the electric circuit portion may be monolithically formed on a silicon substrate that forms the MEMS chip 11.

In the meantime, in the microphone unit 1 according to the first embodiment, a wall surface 122a (in the present embodiment, the entire wall surface of the intra-substrate space 122) of the intra-substrate 122 formed in the mike substrate 12 is covered by a coating layer CL. The covering by the coating layer CL is obtainable by a metal plating process, and the coating layer CL is according to the invention a metal plated layer such as a Cu plated layer and the like. Thanks to the covering by the coating layer CL, it is possible to reduce a likelihood that dust occurs in the intra-substrate space 122 of the mike substrate 12.

In a case where the mike substrate 12 is composed of, for example, a glass epoxy substrate (FR-4 substrate), a fiber-like dust easily occurs from a machined surface (surface to which machining such as severing, scraping or the like is applied) of the mike substrate 12. In a case where the wall surface 122a of the intra-substrate space 122 is not covered by means of the coating layer CL (in a case different from the present embodiment), dust easily enters the MEMS chip 11 that is disposed to cover the opening 121 which connects to the intra-substrate space 122. The invasion of dust into the MEMS chip 11 causes malfunction of the MEMS chip 11. As an example, there is a situation in which dust enters from the through-hole 112 disposed through the fixed electrode 112 and clogs the gap Gp (see Fig. 2) between the fixed electrode 112 and the diaphragm 114. Regarding this point, in the microphone unit 1 according to the first embodiment, thanks to the presence of the coating layer CL, dust is unlikely to occur from the intra-substrate space 122, and it is possible to reduce a likelihood that the MEMS chip 11 malfunctions.

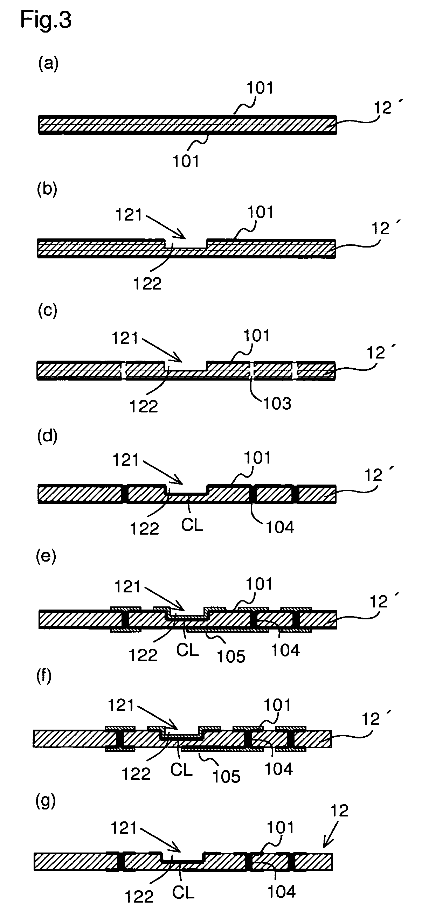

Next, methods for manufacturing the mike substrate 12 and the microphone unit 1 described above are described with chief reference to Fig. 3. Fig. 3 is a sectional view for describing a manufacturing method for the mike substrate that the microphone unit according to the first embodiment includes, of which (a) to (f) show states during the manufacturing, and (g) shows a state in which the mike substrate is completed.

When manufacturing the mike substrate 12, first, a substrate 12' (flat-plated shape), whose upper surface and lower surface are covered by a metal material (electro-conductive material) 101 such as Cu or the like, is prepared (step a; see Fig. 3(a)). The thickness of the substrate 12' is 1.0 mm for example, and the thickness of the electro-conductive material 101 is 0.15 µm.

At a substantially central position of the prepared substrate 12', the substrate 12' is dug from the upper surface to a position in a thickness direction (vertical direction of Fig. 3). In this way, as shown in Fig. 3 (b), the opening 121 having a substantially circular shape when viewed from top and the substantially cylindrical-shaped intra-substrate space 122 (which connects to the opening 121only but does not connect to another opening) connecting to the opening 121 are formed (step b). The digging into the substrate 12' is performed by using, for example, an NC (Numerical Control) apparatus that is able to perform the scrape machining of a 3D object controlling coordinate positions. The size of the intra-substrate space 122 is, for example, 0.6 mm in diameter and 0.5 mm in depth.

In the meantime, here, the substrate (substrate provided with a recess) which is provided with the opening 121 and the intra-substrate space 122 is obtained by using the NC apparatus; however, this is not limiting. In other words, a first substrate (flat-plated shape) provided with a through-hole (formed by a drill or a laser, for example) and a second substrate with no through-hole are attached to each other, whereby one substrate provided with the opening 121 and the intra-substrate space 122 may be obtained.

Next, in the substrate 12' where the opening 121 and the intra-substrate space 122 are formed, a through-hole 103 (e.g., 0.3 mm in diameter) is formed through a portion where it is necessary to electrically connect the upper surface and the lower surface to each other as shown in Fig. 3 (c) (step c). For the forming of the through-hole 103, for example, a drill, a laser, an NC apparatus or the like is used. The portion where it is necessary to electrically connect the upper surface and the lower surface of the substrate 12' to each other is suitably decided on how a circuit structure of the microphone unit is designed. In Fig. 3 (c), three places are shown as the places where to form the through-hole 103; however, this is not limiting. Besides, the step b and the step c may be changed with each other in order.

When the through-hole 103 is formed through the substrate 12', next, a plating process (e.g., electroless copper plating process) is applied to the through-hole 103 to form a through-wiring 104 as shown in Fig. 3 (d) (step d). At this time, the plating process is applied to the wall surface of the intra-substrate space 122 as well. Because of this, at the same time of the forming of the through-wiring 104, the entire wall surface of the intra-substrate space 122 is covered by a metal (e.g., Cu) plated layer CL (coating layer CL).

Here, the forming of the through-wiring 104 and the process of covering the wall surface of the intra-substrate space 122 by means of the coating layer CL may be performed with a method other than the plating process, for example, may be performed with a method (burying, applying and the like) that uses electro-conductive paste and the like.

Next, a portion of the upper surface and the lower surface of the substrate 12' where the wiring pattern is necessary is masked by means of an etching resist 105 as shown in Fig. 3 (e) (step e). At this time, also the coating layer CL (e.g., a Cu plated layer) applied to the wall surface of the intra-substrate space 122 is masked by means of the etching resist 105.

When the masking by means of the etching resist 105 is completed, the substrate 12' is dipped into an etching liquid (step f). In this way, of the electro-conductive material (e.g., Cu) disposed on the upper surface and the lower surface of the substrate 12', a portion which is not covered by the etching resist 105 is removed as shown in Fig. 3 (f).

In the meantime, here, the unnecessary electro-conductive material is removed by the etching; however, this is not limiting, and the unnecessary electro-conductive material may be removed by, for example, laser machining and scrape machining.

When the etching is completed, the washing of the substrate 12' and the removal of the etching resist 105 are performed (step g). In this way, as shown in Fig. 3 (g), the mike substrate 12 is obtained, which includes the opening 121 and the intra-substrate space 122 whose wall surface is covered by the coating layer CL, and is provided with the wiring pattern (inclusive of the through-wiring).

By disposing the MEMS chip 11 onto the upper surface 12a of the mike substrate 12 to cover the opening 121 and further by placing the cover 13 to cover the MEMS chip 11, the microphone unit 1 shown in Fig. 1 is obtained. Here, the MEMS chip 11 is connected to the mike substrate 12 by means of a die bonding material (e.g., an epoxy resin adhesive, a silicone resin adhesive or the like) such that a sound leak does not occur and a gap is not formed between the bottom surface and the upper surface of the mike substrate 12.

Besides, the cover 13 also is connected to the upper surface of the mike substrate 12 by using, for example, an adhesive or an adhesive sheet for air-tight sealing. In a case where the electric circuit portion is mounted onto the mike substrate 12, the MEMS chip 11 and the electric circuit portion are connected to the mike substrate 12, thereafter, the cover 13 is connected to the upper surface (mount surface of the MEMS chip 11 and the like) of the mike substrate 12. The wiring pattern formed on the lower surface of the mike substrate 12 is used as an external electrode.

In the above description, the structure is described, in which the wiring pattern disposed on the mike substrate 12 is formed by means of a subtraction method that uses the etching method; however this is not limiting. In other words, the wiring pattern disposed on the mike substrate 12 may be formed by means of an addition method that uses printing, burying and the like.

### (Second Embodiment)

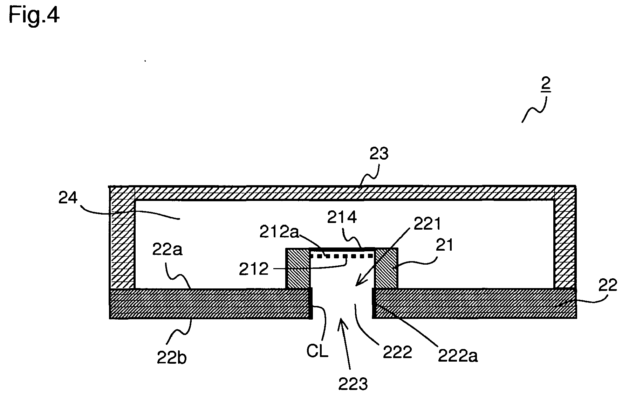

Fig. 4 is a schematic sectional view showing a structure of a microphone unit according to a second embodiment to which the present invention is applied. As shown in Fig. 4, a microphone unit 2 according to the second embodiment includes: a MEMS chip 21; a mike substrate 22 on which the MEMS chip 21 is mounted; and a cover 23. The microphone unit 2 according to the second embodiment functions as an omnidirectional mike.

The structure of the MEMS chip 21 (embodiment of the electro-acoustic conversion device according to the present invention), which has a fixed electrode 212 (which has a plurality of through-holes 212a) and a diaphragm 214, is the same as the structure of the MEMS chip 11 in the first embodiment, accordingly, detailed description is skipped.

The structure of the mike substrate 22 (embodiment of the electro-acoustic conversion device mount substrate according to the present invention) is substantially the same as the structure of the mike substrate 12 in the first embodiment, but is different from the structure of the first embodiment in that an intra-substrate space 222 connecting to a first opening 221 formed through a mount surface (upper surface) of the mike substrate 22 connects to a second opening 223 that is formed through a rear surface (lower surface) 22b opposite to the mount surface of the mike substrate 22. In other words, the mike substrate 22 is not provided with a recess unlike the first embodiment, but provided with a through-hole, by means of the first opening 121, the intra-substrate space 122 and the second opening 223, that penetrates the mike substrate 22 in a thickness direction. Besides, the cover 23 (embodiment of the cover portion according to the present invention) also has substantially the same structure as the cover 13 in the first embodiment, but is different from the structure of the first embodiment in that a sound hole is not disposed.

Here, the mike substrate 22 may be, for example, an FR-4 (glass epoxy substrate) substrate, however, may be another kind of substrate.

In the microphone unit 2 according to the second embodiment, the MEMS chip 21 is disposed to cover the first opening 221 that is formed through the mount surface 22a of the mike substrate 22. The through-hole formed of the first opening 221, the intra-substrate space 222 and the second opening 223 functions as a sound hole. In other words, a sound wave occurring outside the microphone unit 2 reaches a lower surface of the diaphragm 214 via the second opening 223, the intra-substrate space 222 and the first opening 221.

In this way, the diaphragm 214 vibrates, whereby a change in the electrostatic capacity occurs. The microphone unit 2 is structured to fetch the change in the electrostatic capacity as an electric signal and outputs it to outside. Here, a caution item regarding the disposition of the electric circuit portion for fetching the change in the electrostatic capacity of the MEMS chip 21 as the electric signal is the same as the case of the first embodiment.

The microphone unit 2 according to the second embodiment is structured to use a tightly closed space 24 (housing space for housing the MEMS chip 21), which is formed of the mike substrate 22 and the cover 23, as the rear chamber, accordingly, it is easy to enlarge the rear chamber volume. Because of this, it is easy to improve the mike sensitivity.

Here, also in the microphone unit 2 according to the second embodiment, a wall surface 222a (in the present embodiment, the entire wall surface of the intra-substrate space 222) of the intra-substrate space 222 formed in the mike substrate 22 is covered by the coating layer CL. The covering by the coating layer CL is obtainable by a metal plating process, and the coating layer CL is according to the invention a metal plated layer such as a Cu plated layer and the like. The effect of the covering by the coating layer CL is the same as the case of the first embodiment, and also in the microphone unit 2 according to the second embodiment, it is possible to prevent occurrence of dust in the intra-substrate space 222 and reduce malfunction of the MEMS chip 21.

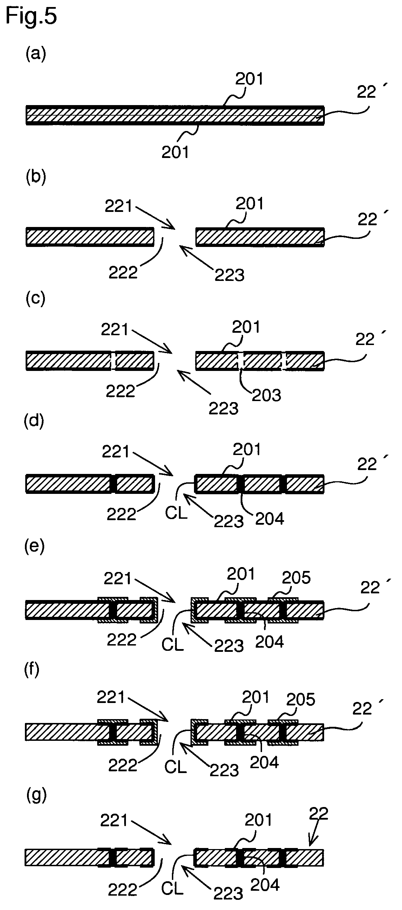

Next, methods for manufacturing the mike substrate 22 and the microphone unit 2 described above are described with chief reference to Fig. 5. Fig. 5 is a sectional view for describing a manufacturing method for the mike substrate that the microphone unit according to the second embodiment includes, of which (a) to (f) show states during the manufacturing, and (g) shows a state in which the mike substrate is completed.

When manufacturing the mike substrate 22, first, a substrate 22' (flat-plated shape), whose upper surface and lower surface are covered by a metal material (electro-conductive material) 201 such as Cu or the like, is prepared (step a; see Fig. 5(a)). The thicknesses of the substrate 22' and the electro-conductive material 201 may be the same as the first embodiment.

At a substantially central position of the prepared substrate 22', along a thickness direction (vertical direction of Fig. 5) of the substrate 22', a hole (e.g., 0.6 mm in diameter), which penetrates from the upper surface to the lower surface, is opened by using, for example, a drill, a laser, an NC apparatus or the like. In this way, the first opening 221 having a substantially circular shape is formed through the upper surface of the substrate 22', the intra-substrate space 222, which has a substantially cylindrical shape and connects to the first opening 221, is formed, and the second opening 223, which is disposed through the lower surface of the substrate 22' and connects to the intra-substrate space 222, is formed (step b; see Fig. 5 (b)).

Thereafter, the same processes as the first embodiment are successively performed.

First, a through-hole 203 is formed through a portion where it is necessary to electrically connect the upper surface and the lower surface to each other as shown in Fig. 5 (c) (step c). Here, the step b and the step c may be changed with each other in order. And, a plating process is performed to form a through-wiring 204 as shown in Fig. 5 (d) (step d). At this time, the plating process is applied to a wall surface of the intra-substrate space 222 as well, and the entire wall surface of the intra-substrate space 222 is covered by the metal (e.g., Cu) plated layer CL (coating layer CL). Here, the forming of the through-wiring 204 and the process of covering the wall surface of the intra-substrate space 222 by means of the coating layer CL may be performed with other methods, which is the same as the first embodiment.

Next, portions of the upper surface and the lower surface of the substrate 22' where a wiring pattern is necessary are masked by means of an etching resist 205 (step e). At this time, also the coating layer CL (e.g., a Cu plated layer) applied to the wall surface of the intra-substrate space 222 is masked by means of the etching resist 105.

When the masking by means of the etching resist 205 is completed, the substrate 22' is dipped into an etching liquid to remove an unnecessary electro-conductive material (e.g., Cu) as shown in Fig. 5 (f) (step f), thereafter, the washing and the removal of the etching resist 205 are performed (step g). In this way, as shown in Fig. 5 (g), the mike substrate 22 is obtained, which includes the first opening 221, the intra-substrate space 222 covered by the coating layer CL and the second opening 223, and is provided with the wiring pattern (inclusive of the through-wiring).

By disposing the MEMS chip 21 onto the upper surface 22a of the mike substrate 22 to cover the opening 221 and further by placing the cover 23 to cover the MEMS chip 21, the microphone unit 2 shown in Fig. 4 is obtained. The connection methods for the MEMS chip 21 and the cover 23 and the caution item in the case of mounting the electric circuit portion onto the mike substrate 22 are the same as the case of the first embodiment. Besides, the wiring pattern disposed on the mike substrate 22 may be formed by means of the addition method instead of the subtraction method, which is also the same as the case of the first embodiment.

### (Third Embodiment)

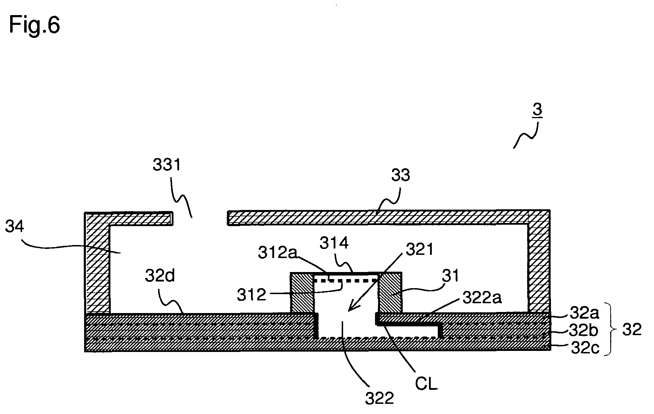

Fig. 6 is a schematic sectional view showing a structure of a microphone unit according to a third embodiment to which the present invention is applied. As shown in Fig. 6, a microphone unit 3 according to the third embodiment includes: a MEMS chip 31; a mike substrate 32 on which the MEMS chip 31 is mounted; and a cover 33. The microphone unit 3 according to the third embodiment functions as an omnidirectional mike.

The structure of the MEMS chip 31 (embodiment of the electro-acoustic conversion device according to the present invention), which has a fixed electrode 312 (which has a plurality of through-holes 312a) and a diaphragm 314, is the same as the structure of the MEMS chip 11 in the first embodiment, accordingly, detailed description is skipped. Besides, also the structure of the cover 33 (embodiment of the cover portion of the present invention) provided with a sound hole 331 is the same as the structure of the cover 13 in the first embodiment, accordingly, detailed description is skipped.

The structure of the mike substrate 32 (embodiment of the electro-acoustic conversion device according to the present invention) is different from the structure of the first embodiment. Because of this, in the microphone unit 3 according to the third embodiment, the rear chamber has a structure different from the microphone unit 1 according to the first embodiment.

The mike substrate 32 formed to have a substantially rectangular shape when viewed from top is composed by attaching three substrates 32a, 32b and 32c to one another as shown in Fig. 6. Although skipped in Fig. 6, the mike substrate 32 is provided with a wiring pattern (inclusive of a through-wiring) that is necessary to apply a voltage to the MEMS chip 31 mounted on the upper surface 32d and to fetch an electric signal from the MEMS chip 31.

Besides, the mike substrate 32 is provided with an opening 321 through the mount surface (upper surface) 32d on which the MEMS chip 31 is mounted, and the MEMS chip 31 is disposed to cover the opening 321. The opening 321 connects to an intra-substrate space 322 that has a substantially L shape in section. The intra-substrate space 322 connects to only the opening 321 but does not connect to another opening. As described above, the mike substrate 32 has the structure obtained by attaching the plurality of substrates, accordingly, it is easy to obtain the intra-substrate space 322 that has the substantially L shape in section. Here, the mike substrate 32 may be, for example, an FR-4 (glass epoxy substrate) substrate, however, may be another kind of substrate.

The intra-substrate space 322 is disposed with intention of increasing a volume of the rear chamber (a tightly closed space that faces a lower surface of the diaphragm 314). Because of the shape (substantially L shape in section), it is possible to enlarge the volume of the intra-substrate space 322 in the present embodiment compared with the intra-substrate space 122 in the first embodiment. Because of this, the microphone unit 3 according to the third embodiment is expectable to be improved in mike sensitivity compared with the microphone unit 1 according to the first embodiment. Here, to make it possible to enlarge the rear chamber volume, the intra-substrate space 322 may be structured to have a hollow space that connects to the digging in the substrate thickness direction, or is not limited to the structure of the present embodiment: for example, a substantially inverse T shape in section and the like may be used.

In the microphone unit 3 according to the third embodiment, when a sound wave input into a housing space 34 (formed of the mike substrate 32 and the cover 33) via the sound hole 331 of the MEMS chip 31 reaches the diaphragm 314, the diaphragm 314 vibrates, whereby a change in the electrostatic capacity occurs. The microphone unit 3 is structured to fetch the change in the electrostatic capacity as an electric signal and outputs it to outside. Here, the caution item regarding the disposition of the electric circuit portion for fetching the change in the electrostatic capacity of the MEMS chip 31 as the electric signal is the same as the case of the first embodiment.

In the meantime, in the microphone unit 3 according to the third embodiment, a portion of a wall surface 322a (a portion except for a bottom wall of the intra-substrate space 322) of the intra-substrate space 322 formed in the mike substrate 32 is covered by the coating layer CL. The covering by the coating layer CL is obtainable by a metal plating process, and the coating layer CL is according to the invention a metal plated layer such as a Cu plated layer and the like. The effect of the covering by the coating layer CL is the same as the case of the first embodiment, and also in the microphone unit 3 according to the third embodiment, it is possible to prevent occurrence of dust in the intra-substrate space 322 and reduce malfunction of the MEMS chip 31.

Here, of course, a structure may be employed, in which also the bottom wall of the intra-substrate space 322 is covered by the coating layer CL. In the present embodiment, the structure is employed, in which the mike substrate 32 is formed by attaching the plurality of substrates 32a to 32c to one another, and the bottom wall of the intra-substrate space 32 is formed of an upper surface of the substrate 32c. The upper surface of the substrate 32c is not a surface to which machining such as severing, scraping and the like is applied, accordingly, dust is unlikely to occur. Because of this, in the present embodiment, the structure is employed, in which the bottom wall of the intra-substrate space 322 is not covered by means of the coating layer CL.

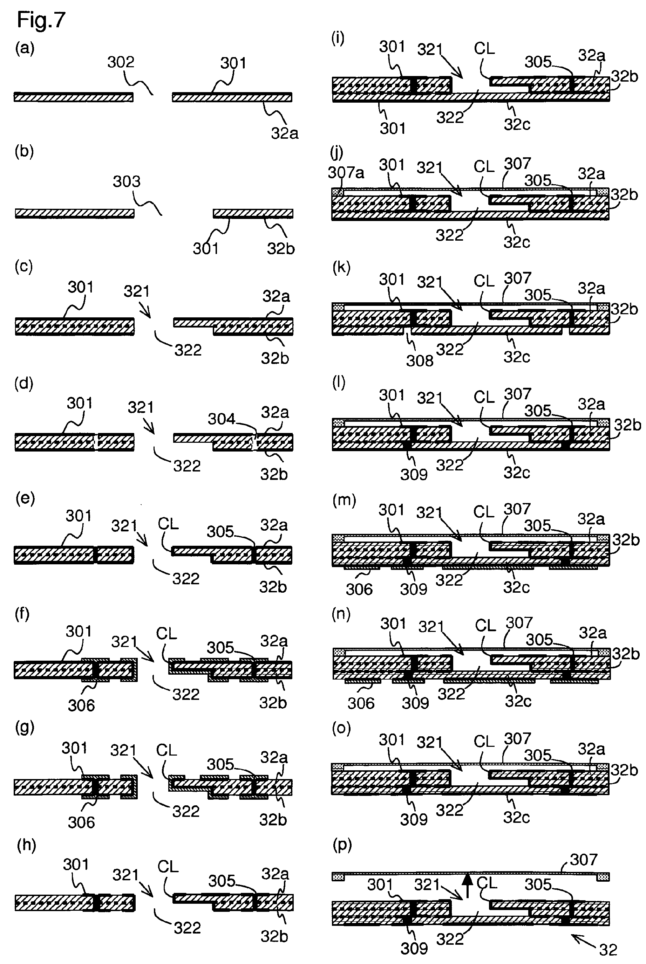

Next, methods for manufacturing the mike substrate 32 and the microphone unit 3 described above are described with chief reference to Fig. 7. Fig. 7 is a sectional view for describing a manufacturing method for the mike substrate that the microphone unit according to the third embodiment includes, of which (a) to (o) show states during the manufacturing, and (p) shows a state in which the mike substrate is completed.

When manufacturing the mike substrate 32, first, a first substrate 32a (flat-plated shape), whose upper surface is covered by, for example, a metal material (electro-conductive material) 301 such as Cu or the like, is prepared. And, along a thickness direction (vertical direction of Fig. 7) of the first substrate 32a, a first through-hole 302 having a substantially circular shape when viewed from top, which penetrates from the upper surface to the lower surface, is opened by using, for example, a drill, a laser, an NC apparatus or the like (step a; see Fig. 7 (a)). The forming position of the first through-hole 302 is a substantially central position of the first substrate 32a. Here, the thickness of the first substrate 32a is 0.3 mm for example, and the thickness of the electro-conductive material 301 is 0.15 µm. Besides, the diameter of the first through-hole 302 is 0.6 mm.

Besides, a second substrate 32b (flat-plated shape), whose lower surface is covered by the metal material (electro-conductive material) 301 such as Cu or the like, is prepared. The thicknesses of the second substrate 32b and the electro-conductive material 301 are the same as the case of the first substrate 32a. And, along a thickness direction (vertical direction of Fig. 7) of the second substrate 32b, a second through-hole 303 having a substantially circular shape when viewed from top, which penetrates from the upper surface to the lower surface, is opened by using, for example, a drill, a laser, an NC apparatus or the like (step b; see Fig. 7 (b)). The second through-hole 303 is disposed at a position that overlaps the first through-hole 302, and is disposed larger than the first through-hole 302 in diameter. Here, of course, the order of the step a and the step b may be inverse.

Next, of the lower surface of the first substrate 32a and the upper surface of the second substrate 32b, an adhesive is applied onto at least one, and the first substrate 32a and the second substrate 32b are attached to each other by pressing (step c; see Fig. 7 (c)). In this way, the opening 321 of the mount surface on which the MEMS chip 31 is mounted is obtained, and the intra-substrate space 322 (substantially L shape in section) connecting to the opening 312 is obtained. Here, instead of the adhesive, an adhesive sheet (e.g., a thermoplastic sheet having a thickness of about 50 µm) may be used, or the first substrate 32a and the second substrate 32b may be attached by means of thermocompression.

Besides, the substrate formed by attaching the first substrate 32a and the second substrate 32b shown in Fig. 7 (c) may be formed of one substrate. In this case, a substrate whose upper surface and lower surface are provided with an electro-conductive material is prepared. And, a digging is formed onto the substrate from both of the upper surface and the lower surface by using an NC apparatus. If the area of the digging formed from the upper surface and the area of the digging formed from the lower surface are made different, the same substrate as shown in Fig. 7 (c) is obtained.

Next, a third through-hole 304 (e.g., 0.3 mm in diameter) is formed through a portion where electric connection is necessary between the upper surface of the first substrate 32a and the lower surface of the second substrate 32b (step d; see Fig. 7 (d)). For the forming of the through-hole 304, for example, a drill, a laser, an NC apparatus or the like is used.

Next, a plating process (e.g., electroless copper plating process) is applied to the third through-hole 304 to form a first through-wiring 305 as shown in Fig. 7 (e) (step e). At this time, the plating process is applied to a wall surface as well of the intra-substrate space 322, and the entire wall surface of the intra-substrate space 322 is covered by the metal (e.g., Cu) plated layer CL (coating layer CL). Here, the forming of the first through-wiring 305 and the process of covering the wall surface of the intra-substrate space 322 by mans of the coating layer CL may be performed with a method other than the plating process, for example, may be performed with a method (burying, applying and the like) that uses electro-conductive paste and the like.

Next, portions of the upper surface of the first substrate 32a and the lower surface of the second substrate 32b where a wiring pattern is necessary are masked by means of an etching resist 306 (step f; see Fig. 7 (f)). At this time, also the coating layer CL (e.g., a Cu plated layer) applied to the wall surface of the intra-substrate space 322 is masked by means of the etching resist 306.

Next, the first substrate 32a and the second substrate 32b in a relationship of being attached to each other are dipped into an etching liquid. In this way, of the electro-conductive material (e.g., Cu) disposed on the substrate, a portion which is not covered by the etching resist 306 is removed (step g; Fig. 7 (g)). In the meantime, here, the unnecessary electro-conductive material is removed by the etching; however, this is not limiting, and the unnecessary electro-conductive material may be removed by, for example, laser machining and scrape machining.

Next, the substrate dipped in the etching liquid is washed, thereafter, the removal of the etching resist 306 is performed (step h; see Fig. 7 (h)). And, the third substrate 32c (embodiment of another substrate according to the present invention) whose lower surface is covered by the electro-conductive material 301 is attached onto the lower surface of the second substrate 32b (step i; see Fig. 7 (i)). The thicknesses of the third substrate 32c and the electro-conductive material are the same as the cases of the first substrate 32a and the second substrate 32b. The attachment of the third substrate 32c onto the second substrate 32b may be performed by means of the same method as the attachment of the first substrate 32a and the second substrate 32b.

Next, a protection cover 307 is mounted to cover and close tightly the entire upper surface of the first substrate 32a (step j; see Fig. 7 (j)). In the present embodiment, the protection cover 307 has a box shape, and an outer edge portion 307a is bonded and fixed onto the first substrate 32a with an opening of the box facing downward. At a position other than the outer edge portion 307a, a gap is formed between the first substrate 32a and the protection cover 307. Here, the shape of the protection cover 307 is not limited to this, and may be a flat-plated shape. In a case where the protection cover 307 has a flat-plated shape, the entire surface may be bonded to the upper surface of the first substrate 32a.

The step of mounting the protection cover 307 is disposed for the purpose of preventing a substrate treatment liquid from invading the intra-substrate space 322 during later substrate manufacturing processes and the finally obtained electro-acoustic conversion device mount substrate 32 from being contaminated. In detail, in a case where the protection cover 307 is not present, there is a likelihood that the plating liquid and the etching liquid invade the intra-substrate space 322 during the plating, etching and washing steps and residues remain to contaminate the substrate. In this point, as in the present embodiment, by mounting the protection cover 307, it is possible to prevent the contamination of the substrate.

Next, a fourth through-hole 308 having a substantially circular shape when viewed from top is opened, which extends from the lower surface of the third substrate 32c to the lower surface of the second substrate 32b (step k; see Fig. 7 (k)). The fourth through-hole 308 is openable by means of, for example, a laser, an NC apparatus and the like, and it is possible to form the diameter to be about 0.5 mm. Here, the order of the step i to the step k may be changed suitably.

Next, a plating process (e.g., electroless copper plating process) is applied to the fourth through-hole 308 to form a second through-wiring 309 as shown in Fig. 7 (1) (step 1). In this way, electric connection between the wiring pattern on the lower surface of the second substrate 32b and the electro-conductive material 301 on the lower surface of the third substrate 32c is performed. When performing the plating process, the etching liquid does not invade the intra-substrate space 322 thank to the presence of the protection cover 307. Here, the forming of the second through-wiring 309 may be performed by means of a method other than the plating process, for example, may be performed by means of a method (burying, applying and the like) that uses electro-conductive paste and the like.

Next, a portion of the lower surface of the third substrate 32c where a wiring pattern is necessary is masked by means of the etching resist 306 (step m; see Fig. 7(m)). Next, the substrate (which is formed by attaching the first substrate 32a, the second substrate 32b and the third substrate 32c to one another) is dipped into the etching liquid to remove an unnecessary electro-conductive material (e.g., Cu) on the lower surface of the third substrate 32c (step n; see Fig. 7 (n)). At this time, the etching liquid does not invade the intra-substrate space 322 thank to the presence of the protection cover 307.

In the meantime, here, the unnecessary electro-conductive material is removed by the etching; however, this is not limiting, and the unnecessary electro-conductive material may be removed by, for example, laser machining and scrape machining.

When the etching is completed, the substrate washing is performed, and further, the removal of the etching resist 306 is performed (step o; see Fig. 7 (o)). And, finally, as shown in Fig. 7 (p), the bonded portion of the protection cover 307 is demounted to separate the protection cover 307 (step p). In this way, the mike substrate 32 is obtained, which includes the opening 321 and the intra-substrate space 322 whose wall surface is partially covered by the coating layer CL, and is provided with the wiring pattern (inclusive of the through-wiring).

By disposing the MEMS chip 31 onto the upper surface 32d of the mike substrate 32 to cover the opening 321 and further by placing the cover 33 to cover the MEMS chip 31, the microphone unit 3 shown in Fig. 6 is obtained. The connection methods of the MEMS chip 31 and the cover 33 and the caution item in the case of mounting the electric circuit portion onto the mike substrate 32 are the same as the case of the first embodiment. Besides, the wiring pattern disposed on the mike substrate 32 may be formed by means of the addition method instead of the subtraction method, which is also the same as the case of the first embodiment.

### (Fourth Embodiment)

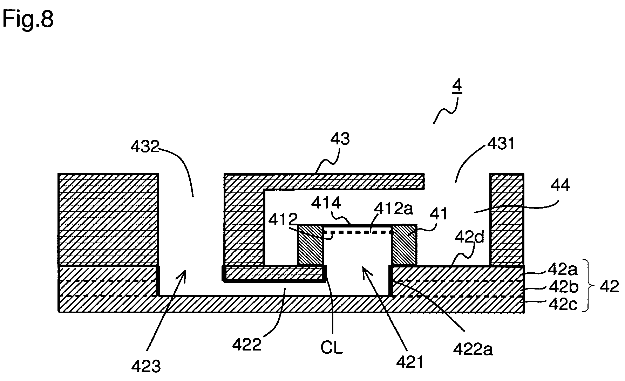

Fig. 8 is a schematic sectional view showing a structure of a microphone unit according to a fourth embodiment to which the present invention is applied. As shown in Fig. 8, a microphone unit 4 according to the fourth embodiment includes: a MEMS chip 41; a mike substrate 42 on which the MEMS chip 41 is mounted; and a cover 43. The microphone unit 4 according to the fourth embodiment functions as a bidirectional differential mike.

The structure of the MEMS chip 41 (embodiment of the electro-acoustic conversion device according to the present invention), which has a fixed electrode 412 (which has a plurality of through-holes 412a) and a diaphragm 414, is the same as the structure of the MEMS chip 11 according to the first embodiment, accordingly, detailed description is skipped.

The structure of the mike substrate 42 (embodiment of the electro-acoustic conversion device according to the present invention) is different from the structures of the first, second and third embodiments. The mike substrate 42 formed to have a substantially rectangular shape when viewed from top is composed by attaching three substrates 42a, 42b and 42c to one another as shown in Fig. 8. Although skipped in Fig. 8, the mike substrate 42 is provided with a wiring pattern (inclusive of a through-wiring) that is necessary to apply a voltage to the MEMS chip 41 mounted on the upper surface 42d and to fetch an electric signal from the MEMS chip 41.

Besides, the mike substrate 42 is provided with a first opening 421 near a center of the mount surface (upper surface) 42d on which the MEMS chip 11 is mounted, and the MEMS chip 41 is disposed to cover the first opening 421. The first opening 421 connects to an intra-substrate space 422 that has a substantially U shape in section. The intra-substrate space 422 connects to not only the first opening 421 but also to a second opening 423 that is formed through the mount surface 42d of the mike substrate 42. As described above, the mike substrate 42 has the structure obtained by attaching the plurality of substrates, accordingly, it is easy to obtain the intra-substrate space 422 that has the first opening 421, the intra-substrate space 422 and the second opening 423. Here, the mike substrate 42 may be, for example, an FR-4 (glass epoxy substrate) substrate, however, may be another kind of substrate.

The cover 43, which is formed to have a substantially rectangular-parallelepiped shape, is placed over the mike substrate 42, thereby collaborating with the mike substrate 42 to form a housing space 44 that houses the MEMS chip 41. The cover 43 is provided with a first sound hole 431 that communicates with the housing space 44. Besides, the cover 33 is provided with a second sound hole 432 that communicates with the intra-substrate space 422 via the second opening 423. Here, the cover 43 is an embodiment of the cover portion of the present invention.

In the microphone unit 4 according to the fourth embodiment, a sound wave input into the housing space 44 via the first sound hole 431 reaches an upper surface of the diaphragm 414. Besides, a sound wave input into the intra-substrate space 422 via the second sound hole 432 reaches a lower surface of the diaphragm 414. Because of this, when a sound occurs outside the microphone unit 4, the diaphragm 414 vibrates thanks to a difference between a sound pressure acting on the upper surface and a sound pressure acting on the lower surface.

A sound pressure (amplitude of a sound wave) of a sound wave is in inverse proportion to a distance from a sound source. And, the sound pressure attenuates sharply at a position near the sound source, and attenuate more slowly at a position that is more distant from the sound source. Because of this, in a case where a distance from the sound source to the upper surface of the diaphragm 414 and a distance from the sound source to the lower surface of the diaphragm 414 are different from each other, a user voice, which occurs near the microphone unit 4 and enters from the upper surface and the lower surface of the diaphragm 414, generates a large sound pressure difference between the upper surface and the lower surface of the diaphragm 414 to vibrate the diaphragm. On the other hand, noises from distant places, which enter from the upper surface and the lower surface of the diaphragm 414 have substantially the same sound pressures, accordingly, they cancel out each other and hardly vibrate the diaphragm.

Accordingly, the electric signal fetched by means of the vibration of the diaphragm 414 is regardable as an electric signal from which the noise is removed and which indicates the user voice. In other words, the microphone unit 4 according to the present embodiment is suitable for a close-talking mike that is required to alleviate a distant noise and collect a near sound.

Here, the electric circuit portion for fetching the change in the electrostatic capacity of the MEMS chip 41 as the electric signal may be disposed, for example, in the housing space 44, or outside the microphone unit. Besides, the electric circuit portion may be monolithically formed on the silicon substrate that forms the MEMS chip 41.

In the meantime, in the microphone unit 4 according to the fourth embodiment, a portion of a wall surface 422a of the intra-substrate space 422 formed in the mike substrate 42 is covered by the coating layer CL. The covering by the coating layer CL is obtainable by a metal plating process, and the coating layer CL is according to the invention a metal plated layer such as a Cu plated layer and the like. The effect of the covering by the coating layer CL is the same as the case of the first embodiment, and also in the microphone unit 4 according to the fourth embodiment, it is possible to prevent occurrence of dust in the intra-substrate space 422 and reduce malfunction of the MEMS chip 41.

Here, of course, a structure may be employed, in which the entire wall surface that forms the intra-substrate space 422 is covered by the coating layer CL. In the present embodiment, the structure is employed, in which the mike substrate 42 is formed by attaching the plurality of substrates 42a to 42c to one another. A portion (wall surface) where the coating layer CL of the intra-substrate space 422 is not disposed is formed of an upper surface of the third substrate 42c. This portion is not a surface to which machining such as severing, scraping and the like is applied, accordingly, dust is unlikely to occur. Because of this, in the present embodiment, the structure is employed, in which a portion of the wall surface of the intra-substrate space 422 is not covered by means of the coating layer CL.

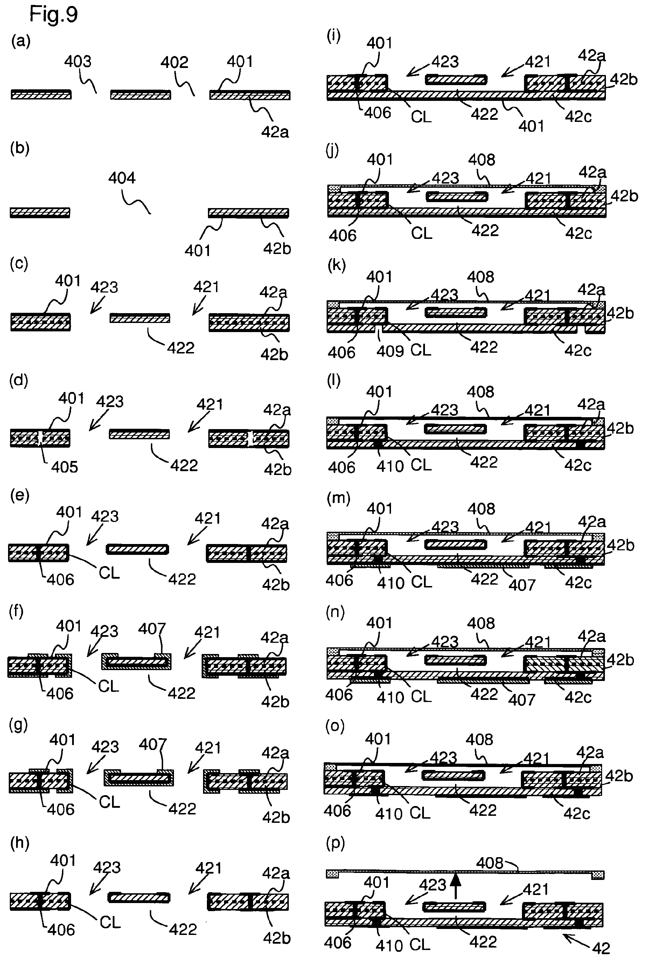

Next, methods for manufacturing the mike substrate 42 and the microphone unit 4 described above are described with chief reference to Fig. 9. Fig. 9 is a sectional view for describing a manufacturing method for the mike substrate that the microphone unit according to the fourth embodiment includes, of which (a) to (o) show states during the manufacturing, and (p) shows a state in which the mike substrate is completed.

When manufacturing the mike substrate 42, first, a first substrate 42a (flat-plated shape), whose upper surface is covered by, for example, a metal material (electro-conductive material) 401 such as Cu or the like, is prepared. And, along a thickness direction (vertical direction of Fig. 9) of the first substrate 42a, a first through-hole 402 and a second through-hole 403 having a substantially circular shape, which penetrate from the upper surface to the lower surface, are opened by using, for example, a drill, a laser, an NC apparatus or the like (step a; see Fig. 9 (a)). Here, the thickness of the first substrate 42a is 0.3 mm for example, and the thickness of the electro-conductive material 401 is 0.15 µm. Besides, the diameters of the first through-hole 402 and the second through-hole 403 are 0.6 mm. Here, the shapes of the first through-hole 420 and the second through-hole 403 are the same as each other, however, may have different shapes.

Besides, a second substrate 42b (flat-plated shape), whose lower surface is covered by the metal material (electro-conductive material) 401 such as Cu or the like, is prepared. The thicknesses of the second substrate 42b and the electro-conductive material 401 are the same as the case of the first substrate 42a. And, along a thickness direction (vertical direction of Fig. 9) of the second substrate 42b, a third through-hole 404 having a substantially rectangular shape when viewed from top, which penetrates from the upper surface to the lower surface, is opened by using, for example, a drill, a laser, an NC apparatus or the like (step b; see Fig. 9 (b)). The third through-hole 404 is disposed to overlap the first through-hole 402 and the second through-hole 403.

Here, in the present embodiment, a right end of the third through-hole 404 is formed to be situated at the same position of a right end of the first through-hole 402, while a left end of the third through-hole 404 is formed to be situated at the same position of a left end of the second through-hole 403; however, this structure is not limiting. For example, a structure may be employed, in which the left and right ends of the third through-hole 404 are more widened to the left and right than the present embodiment. Besides, also the shape of the third through-hole 404 is not limited to the shape (substantially rectangular shape when viewed from top) of the present embodiment, and is suitably modifiable. Here, of course, the order of the step a and the step b may be inverse.

Next, the lower surface of the first substrate 42a and the upper surface of the second substrate 42b are attached to each other (step c; see Fig. 9 (c)). In this way, the first opening 421 of the mount surface on which the MEMS chip 41 is mounted is obtained, the intra-substrate space 422 (substantially U shape in section) connecting to the first opening 421 is obtained, and the second opening 423 is obtained which is disposed, independent of the first opening 421, on the mount surface on which the MEMS chip 41 is mounted and connects to the intra-substrate space 422. Here, the attachment of the first substrate 42a and the second substrate 42b may be performed in the same way as the attachment of the first substrate 32a and the second substrate 32b in the third embodiment. Besides, in the same way as the case of the third embodiment, the substrate (board formed by attaching the first substrate 42a and the second substrate 42b) having the structure shown in Fig. 9 (c) may be formed of one substrate.

Hereinafter, although there is a difference in the substrate shape, the manufacturing of the mike substrate 42 is performed in a procedure similar to the case of the third embodiment. Points overlapping the third embodiment are skipped or described briefly.

A fourth through-hole 405 (e.g., 0.3 mm in diameter) is formed through a portion where electric connection is necessary between the upper surface of the first substrate 42a and the lower surface of the second substrate 42b by using, for example, a drill, a laser, an NC apparatus or the like (step d; see Fig. 9 (d)). Next, by applying a plating process (e.g., electroless copper plating process) onto the fourth through-hole 405, a first through-wiring 406 shown in Fig. 9 (e) is formed (step e). At this time, the plating process is also applied to a wall surface of the intra-substrate space 422, and the entire wall surface of the intra-substrate space 422 is covered by the metal plated layer CL (coating layer CL).

Here, the forming of the through-wiring 406 and the process of covering the wall surface of the intra-substrate space 422 by means of the coating layer CL may be performed with a method other than the plating process, which is the same as the case of the third embodiment.

Next, portions of the upper surface of the first substrate 42a and the lower surface of the second substrate 42b where a wiring pattern is necessary to be formed are masked by means of an etching resist 407 (step f; see Fig. 9 (f)). At this time, also the coating layer CL applied to the wall surface of the intra-substrate space 422 is masked by means of the etching resist 407. And, the removal of the unnecessary electro-conductive material 401 is performed by means of the etching liquid (step g; see Fig. 9 (g)), and after the etching, the washing and the removal of the etching resist 407 are performed (step h; see Fig. 9 (h)).

In the meantime, here, the unnecessary electro-conductive material is removed by the etching; however, this is not limiting, and the unnecessary electro-conductive material may be removed by, for example, laser machining and scrape machining.

Next, the third substrate 42c (embodiment of another substrate according to the present invention) whose lower surface is covered by the electro-conductive material 401 is attached onto the lower surface of the second substrate 42b (step i; see Fig. 9(i)). Next, a protection cover 408 is mounted to cover and close tightly the entire upper surface of the first substrate 42a (step j; see Fig. 9 (j)). The shape and the mounting method of the protection cover 408 and the reason for using the protection cover 408 are the same as the case of the third embodiment. Next, a fifth through-hole 409 having a substantially circular shape when viewed from top is opened by using, for example, a laser, an NC apparatus or the like, which extends from the lower surface of the third substrate 42c to the lower surface of the second substrate 42b (step k; see Fig. 9 (k)). Here, the order of the step i to the step k may be changed suitably.

Next, a plating process (e.g., electroless copper plating process) is applied to the fourth through-hole 409 to form a second through-wiring 410 as shown in Fig. 9 (1) (step 1). In this way, electric connection between the wiring pattern on the lower surface of the second substrate 42b and the electro-conductive material 401 on the lower surface of the third substrate 42c is performed. When performing the plating process, the etching liquid does not invade the intra-substrate space 422 thank to the presence of the protection cover 408. Here, the forming of the second through-wiring 410 may be performed by means of a method other than the plating process, which is the same as the third embodiment.

Next, a portion of the lower surface of the third substrate 42c where a wiring pattern is necessary is masked by means of an etching resist 407 (step m; see Fig. 9(m)); the substrate (which is formed by attaching three substrates of the first substrate 42a to the third substrate 42c to one another) is dipped into the etching liquid to remove an unnecessary electro-conductive material (e.g., Cu) on the lower surface of the third substrate 42c (step n; see Fig. 9 (n)). At this time, the etching liquid does not invade the intra-substrate space 422 thank to the presence of the protection cover 408.

In the meantime, here, the unnecessary electro-conductive material is removed by the etching; however, this is not limiting, and the unnecessary electro-conductive material may be removed by, for example, laser machining and scrape machining.

When the etching is completed, the substrate washing is performed, and further, the removal of the etching resist 407 is performed (step o; see Fig. 9 (o)). And, finally, as shown in Fig. 9 (p), the bonded portion of the protection cover 408 is demounted to separate the protection cover 408 (step p). In this way, the mike substrate 42 is obtained, which includes the first opening 421, the second opening 423, and the intra-substrate space 422 whose wall surface is partially covered by the coating layer CL, and is provided with the wiring pattern (inclusive of the through-wiring).

By disposing the MEMS chip 41 onto the upper surface 42d of the mike substrate 42 to cover the first opening 421 and further by placing the cover 43 such that the second sound hole 432 overlies the second opening 423, the microphone unit 4 shown in Fig. 8 is obtained. The connection methods of the MEMS chip 41 and cover 43 and the caution item in the case of mounting the electric circuit portion onto the mike substrate 42 are the same as the case of the first embodiment. Besides, the wiring pattern disposed on the mike substrate 42 may be formed by means of the addition method instead of the subtraction method, which is also the same as the case of the first embodiment.

### (Others)

The microphone units 1 to 4, the electro-acoustic conversion device mount substrates (mike substrates) 12, 22, 32, 42, and the manufacturing methods of them according to the embodiments described above are mere examples of the present invention, and the application scope of the present invention is not limited to the embodiments described above. In other words, it is possible to add various modifications to the embodiments described above without departing the object of the present invention.

For example, in the embodiments described above, the structure is employed, in which the electro-acoustic conversion device is the MEMS chip that is formed by using a semiconductor manufacturing technology; however, the structure is not limiting. The electro-acoustic conversion device formed of the MEMS chip is especially weak for dust, accordingly, the present invention is preferably applied; however, the present invention is applicable to a case where an electro-acoustic conversion device other than the MEMS chip is used.

Besides, in the above embodiments, the case is described, in which the electro-acoustic conversion device is a so-called capacitor type microphone; however, the present invention is applicable to a case where the electro-acoustic conversion device is a microphone (e.g., a moving conductor (dynamic) microphone, an electromagnetic (magnetic) microphone, a piezo-electric microphone and the like) which has a structure other than the capacitor type microphone.

Besides, in the above embodiments, the case is described, in which the coating layer disposed in the intra-substrate space of the electro-acoustic conversion device mount substrate is a metal layer such as a plated layer and the like; however, this is not limiting. In short, the coating layer disposed in the intra-substrate space may be a layer other than the metal layer if the layer has the function to alleviate dust that has a likelihood of occurring in the intra-substrate space.

In addition, the shapes of the electro-acoustic conversion device and the microphone unit (inclusive of the opening, the intra-substrate space and the like that are disposed in them) are not limited to the shapes according to the embodiments, and of course, modifiable into various shapes.

### Industrial Applicability

The present invention is suitable for a microphone unit that is included in voice input apparatuses such as, for example, a mobile phone and the like.

### Reference Signs List

1, 2, 3, 4 microphone units
11, 21, 31, 41 MEMS chips (electro-acoustic conversion devices)
12, 22, 32, 42 mike substrates (electro-acoustic conversion device mount substrates)
12a, 22a, 32d, 42d mount surfaces
13, 23, 33, 43 covers (cover portions)
14, 24, 34, 44 housing spaces
22b rear surface opposite to mount surface
31 c, 41 c third substrates (other substrates)
103, 203, 304, 308, 405, 409 through-holes for through-wiring
112,212,312,412 fixed electrodes
114, 214, 314, 414 diaphragms
121, 221, 312, 322 openings or first openings
122, 222, 322, 422 intra-substrate spaces
122a, 222a, 322a, 422a walls surfaces of intra-substrate spaces
223, 423 second openings (other openings)
307, 408 protection covers
CL coating layer

## Claims

1. An electro-acoustic conversion device mount substrate (12, 22, 32, 42) that is mounted with an electro-acoustic conversion device (11, 21, 31, 41) which converts an input sound into an electric signal, comprising:
a mount surface (12a, 22a, 32d, 42d) on which the electro-acoustic conversion device (11, 21, 31, 41) is mounted and which is provided with an opening (121, 221, 321, 421) that is covered by the electro-acoustic conversion device (11, 21, 31, 41); and
an intra-substrate space (122, 222, 322, 422) connected to the opening (121, 221,321,421),
**characterized in that**
at least a portion of a wall surface (122a, 222a, 322a, 422a) that forms the intra-substrate space (122, 222, 322, 422) is covered by a metal plated layer (CL) .

2. The electro-acoustic conversion device mount substrate according to claim 1, wherein
a glass epoxy material is used as a substrate material.

3. The electro-acoustic conversion device mount substrate according to any one of claims 1 to 2, wherein
the intra-substrate space (122, 222, 322, 422) does not connect to another opening (131, 331, 431) other than the opening (121, 221, 321, 421).

4. The electro-acoustic conversion device mount substrate according to any one of claims 1 to 2, wherein
the intra-substrate space (122, 222, 322, 422) connects to another opening (223) other than the opening (121, 221, 321, 421).

5. The electro-acoustic conversion device mount substrate according to claims 4, wherein
the another opening (223) is disposed through a rear surface (22b) opposite to the mount surface (12a, 22a, 32d, 42d).

6. The electro-acoustic conversion device mount substrate according to claims 4, wherein
the another opening (223) is disposed through the mount surface (12a, 22a, 32d, 42d).

7. A microphone unit (1, 2, 3, 4) comprising:
an electro-acoustic conversion device mount substrate (12, 22, 32, 42) according to any one of claims 1 to 6;
an electro-acoustic conversion device (11, 21, 31, 41) that is mounted on the mount surface (12a, 22a, 32d, 42d) to cover the opening (121, 221, 321,421); and
a cover portion (13, 23, 33, 43) that collaborates with the electro-acoustic conversion device mount substrate (12, 22, 32,42) to form a housing space (14, 24, 34, 44) for housing the electro-acoustic conversion device (11, 21, 31, 41).

8. The microphone unit according to claim 7, wherein
the electro-acoustic conversion device (11, 21, 31, 41) is a MEMS chip that includes: a diaphragm (114, 214, 314, 414) and a fixed electrode (112, 212, 312, 412) that is disposed to oppose the diaphragm (114, 214, 314, 414) with a gap (Gp) therebetween and forms a capacitor together with the diaphragm (114, 214, 314, 414).

9. A method for manufacturing an electro-acoustic conversion device mount substrate (12, 22, 32, 42) that is mounted with an electro-acoustic conversion device (11, 21, 31, 41) which converts an input sound into an electric signal, comprising:
a first step for preparing a substrate (12', 22', 32a, 32b, 42a, 42b) that is provided with an opening (121, 221, 321, 421) formed through a mount surface (12a, 22a, 32d, 42d) of the substrate (12', 22', 32a, 32b, 42a, 42b) and covered by the electro-acoustic conversion device (11, 21, 31, 41), and an intra-substrate space (122, 222, 322, 422) connected to the opening (121,221,321,421);
**characterized by**
a second step for applying a metal plating process to a wall surface that forms the intra-substrate space (122, 222, 322, 422); and
a third step for forming a wiring pattern on a substrate outer surface by performing an etching process after the plating process.

10. The method for manufacturing an electro-acoustic conversion device mount substrate (12, 22, 32,42) according to claim 9, further comprising:
a fourth step for attaching another substrate (32c, 42c) to a rear surface opposite to a surface of the substrate (12', 22', 32a, 32b, 42a, 42b), on which the wiring pattern is formed in the third process, through which the opening (121,221, 321,421) is formed;
a fifth step for mounting a protection cover (307, 408) to cover an entire surface of the substrate (12', 22', 32a, 32b, 42a, 42b), on which the wiring pattern is formed in the third process, through which the opening (121, 221, 321, 421) is formed;
a sixth step for forming a through-hole (308, 409) for a through-wiring (309, 410) through the another substrate (32c, 42c);
a seventh step for applying a plating process to the through-hole (308, 409) for the through-wiring (309, 410) that is formed in the sixth step after completion of the fourth step, the fifth step and the sixth step that are performed in random order;
an eighth step for forming a wiring pattern on the another substrate (32c, 42c) by means of an etching process after the seventh step is completed; and
a ninth step for separating the protection cover (307, 408) after the wiring pattern is formed on the another substrate (32c, 42c).

11. A method for manufacturing a microphone unit (1, 2, 3, 4) comprising:
a step for manufacturing an electro-acoustic conversion device mount substrate (12, 22, 32, 42) by means of a manufacturing method according to claim 9 or 10;
a step for mounting the electro-acoustic conversion device (11, 21, 31, 41) onto the electro-acoustic conversion device mount substrate (12, 22, 32, 42) to cover the opening (121, 221, 321, 421); and
a step for covering a cover portion (13, 23, 33, 43) onto the electro-acoustic conversion device mount substrate (12, 22, 32, 42) to cover the electro-acoustic conversion device (11, 21, 31,41).

## Patentansprüche

1. Montagesubstrat (12, 22, 32, 42) für eine elektroakustische Wandlervorrichtung, das mit einer elektroakustischen Wandlervorrichtung (11, 21, 31, 41) montiert ist, die einen Eingangsschall in ein elektrisches Signal umwandelt, umfassend:
eine Montagefläche (12a, 22a, 32d, 42d), an der die elektroakustische Wandlervorrichtung (11, 21, 31, 41) montiert ist und die mit einer Öffnung (121, 221, 321, 421) versehen ist, die von der elektroakustischen Wandlervorrichtung (11, 21, 31, 41) bedeckt ist; und
einen Innensubstratraum (122, 222, 322, 422), der mit der Öffnung (121, 221, 321, 421) verbunden ist,
**dadurch gekennzeichnet, dass**
zumindest ein Abschnitt einer Wandfläche (122a, 222a, 322a, 422a), der den Innensubstratraum (122, 222, 322, 422) bildet, durch eine metallplattierte Schicht (CL) bedeckt ist.

2. Montagesubstrat für eine elektroakustische Wandlervorrichtung nach Anspruch 1, wobei ein Glasepoxidmaterial als ein Substratmaterial verwendet ist.

3. Montagesubstrat für eine elektroakustische Wandlervorrichtung nach einem der Ansprüche 1 oder 2, wobei
der Innensubstratraum (122, 222, 322, 422) nicht mit einer anderen Öffnung (131, 331, 431) mit Ausnahme der Öffnung (121, 221, 321, 421) verbunden ist.

4. Montagesubstrat für eine elektroakustische Wandlervorrichtung nach einem der Ansprüche 1 bis 2, wobei der Innensubstratraum (122, 222, 322, 422) mit einer anderen Öffnung (223) mit Ausnahme der Öffnung (121, 221, 321, 421) verbunden ist.

5. Montagesubstrat für eine elektroakustische Wandlervorrichtung nach Anspruch 4, wobei die andere Öffnung (223) durch eine Rückfläche (22b) gegenüberliegend der Montagefläche (12a, 22a, 32d, 42d) angeordnet ist.

6. Montagesubstrat für eine elektroakustische Wandlervorrichtung nach Anspruch 4, wobei die andere Öffnung (223) durch die Montagefläche (12a, 22a, 32d, 42d) angeordnet ist.

7. Mikrofoneinheit (1, 2, 3, 4), umfassend:
ein Montagesubstrat (12, 22, 32, 42) für eine elektroakustische Wandlervorrichtung nach einem der Ansprüche 1 bis 6;
eine elektroakustische Wandlervorrichtung (11, 21, 31, 41), die an der Montagefläche (12a, 22a, 32d, 42d) montiert ist, um die Öffnung (121, 221, 321, 421) zu bedecken; und
einen Abdeckabschnitt (13, 23, 33, 43), der mit dem Montagesubstrat. (12, 22, 32, 42) der elektroakustischen Wandlervorrichtung zusammenwirkt, um einen Gehäuseraum (14, 24, 34, 44) zur Aufnahme der elektroakustischen Wandlervorrichtung (11, 21, 31, 41) zu bilden.

8. Mikrofoneinheit nach Anspruch 7, wobei
die elektroakustische Wandlervorrichtung (11, 21, 31, 41) ein MEMS-Chip ist, der umfasst: eine Membran (114, 214, 314, 414) und eine fixierte Elektrode (112, 212, 312, 412), die so angeordnet ist, dass sie der Membran (114, 214, 314, 414) mit einem Spalt (Gp) dazwischen gegenüberliegt und gemeinsam mit der Membran (114, 214, 314, 414) einen Kondensator bildet.

9. Verfahren zum Herstellen eines Montagesubstrats (12, 22, 32, 42) für eine elektroakustische Wandlervorrichtung, das mit einer elektroakustischen Wandlervorrichtung (11, 21, 31, 41) montiert ist, die einen Eingangsschall in ein elektrisches Signal umwandelt, umfassend:
einen ersten Schritt zum Vorbereiten eines Substrats (12', 22', 32a, 32b, 42a, 42b), das mit einer Öffnung (121, 221, 321, 421), die durch eine Montagefläche (12a, 22a, 32d, 42d) des Substrats (12', 22', 32a, 32b, 42a, 42b) gebildet und von der elektroakustischen Wandlervorrichtung (11, 21, 31, 41) bedeckt ist, und einem Innensubstratraum (122, 222, 322, 422) versehen ist, der mit der Öffnung (121, 221, 321, 421) verbunden ist;
**gekennzeichnet durch**
einen zweiten Schritt zum Anwenden eines Metallplattierungsprozesses auf eine Wandfläche, die den Innensubstratraum (122, 222, 322, 422) bildet; und
einen dritten Schritt zum Formen eines Verdrahtungsmusters auf einer Substrataußenfläche **durch** Ausführen eines Ätzprozesses nach dem Plattierprozess.

10. Verfahren zum Herstellen eines Montagesubstrats (12, 22, 32, 42) für ein elektroakustische Wandlervorrichtung nach Anspruch 9, ferner umfassend:
einen vierten Schritt zum Befestigen eines anderen Substrats (32c, 42c) an einer rückwärtigen Fläche gegenüberliegend einer Fläche des Substrats (12', 22', 32a, 32b, 42a, 42b), an der das Verdrahtungsmuster in einem dritten Prozess ausgebildet ist, durch den die Öffnung (121, 221, 321, 421) gebildet ist;
einen fünften Schritt zum Montieren einer Schutzabdeckung (307, 408) zur Abdeckung einer gesamten Fläche des Substrats (12', 22', 32a, 32b, 42a, 42b), an der das Verdrahtungsmuster in dem dritten Prozess geformt ist, durch den die Öffnung (121, 221, 321, 421) geformt ist;
einen sechsten Schritt zum Formen eines Durchgangslochs (308, 409) für eine Durchgangsverdrahtung (309, 410) für das andere Substrat (32c, 42c);
einen siebten Schritt zum Ausüben eines Plattierprozesses auf das Durchgangsloch (308, 409) für die Durchgangsverdrahtung (309, 410), die in dem sechsten Schritt nach Beendigung des vierten Schrittes, des fünften Schrittes und des sechsten Schrittes, die in zufälliger Reihenfolge ausgeführt werden, gebildet ist;
einen achten Schritt zum Ausbilden eines Verdrahtungsmusters an dem anderen Substrat (32c, 42c) mittels eines Ätzprozesses, nachdem der siebte Schritt beendet ist; und
einen neunten Schritt zum Trennen der Schutzabdeckung (307, 408), nachdem das Verdrahtungsmuster an dem anderen Substrat (32c, 42c) geformt ist.

11. Verfahren zum Herstellen einer Mikrofoneinheit (1, 2, 3, 4), umfassend:
einen Schritt zum Herstellen eines Montagesubstrats (12, 22, 32, 42) für eine elektroakustische Wandlervorrichtung mittels eines Herstellverfahrens nach einem der Ansprüche 9 oder 10;
einen Schritt zum Montieren der elektroakustischen Wandlervorrichtung (11, 21, 31, 41) auf dem Montagesubstrat (12, 22, 32, 42) für die elektroakustische Wandlervorrichtung, um die Öffnung (121, 221, 321, 421) zu bedecken; und
einen Schritt zum Abdecken eines Abdeckabschnitts (13, 23, 33, 43) an dem Montagesubstrat (12, 22, 32, 42) der elektroakustischen Wandlervorrichtung, um die elektroakustische Wandlervorrichtung (11, 21, 31, 41) zu bedecken.

## Revendications

1. Substrat de montage de dispositif de conversion électro-acoustique (12, 22, 32, 42) sur lequel est monté un dispositif de conversion électro-acoustique (11, 21, 31, 41) qui convertit un son d'entrée en un signal électrique, comprenant :
une surface de montage (12a, 22a, 32d, 42d) sur laquelle est monté le dispositif de conversion électro-acoustique (11, 21, 31, 41), et qui est munie d'une ouverture (121, 221, 321, 421) qui est recouverte par le dispositif de conversion électro-acoustique (11, 21, 31, 41) ; et
un espace intra-substrat (122, 222, 322, 422) relié à l'ouverture (121, 221, 321, 421),
**caractérisé en ce que** :
au moins une partie d'une surface de paroi (122a, 222a, 322a, 422a) qui forme l'espace intra-substrat (122, 222, 322, 422) est recouverte par une couche plaquée de métal (CL) .

2. Substrat de montage de dispositif de conversion électro-acoustique selon la revendication 1, dans lequel :
un matériau de verre-époxy est utilisé comme matériau de substrat.

3. Substrat de montage de dispositif de conversion électro-acoustique selon l'une quelconque des revendications 1 et 2, dans lequel :
l'espace intra-substrat (122, 222, 322, 422) n'est pas relié à une ouverture (131, 331, 431) autre que l'ouverture (121, 221, 321, 421).

4. Substrat de montage de dispositif de conversion électro-acoustique selon l'une quelconque des revendications 1 et 2, dans lequel :
l'espace intra-substrat (122, 222, 322, 422) est relié à une ouverture (223) autre que l'ouverture (121, 221, 321, 421).

5. Substrat de montage de dispositif de conversion électro-acoustique selon la revendication 4, dans lequel :
l'autre ouverture (223) est disposée à travers une surface arrière (22b) opposée à la surface de montage (12a, 22a, 32d, 42d).

6. Substrat de montage de dispositif de conversion électro-acoustique selon la revendication 4, dans lequel :
l'autre ouverture (223) est disposée à travers la surface de montage (12a, 22a, 32d, 42d).

7. Unité de microphone (1, 2, 3, 4), comprenant :
un substrat de montage de dispositif de conversion électro-acoustique (12, 22, 32, 42) selon l'une quelconque des revendications 1 à 6 ;
un dispositif de conversion électro-acoustique (11, 21, 31, 41) qui est monté sur la surface de montage (12a, 22a, 32d, 42d) de façon à recouvrir l'ouverture (121, 221, 321, 421) ; et
une partie de couverture (13, 23, 33, 43) qui collabore avec le substrat de montage de dispositif de conversion électro-acoustique (12, 22, 32, 42) pour former un espace de logement (14, 24, 34, 44) pour loger le dispositif de conversion électro-acoustique (11, 21, 31, 41).

8. Unité de microphone selon la revendication 7, dans laquelle :
le dispositif de conversion électro-acoustique (11, 21, 31, 41) est une puce de système micro-électro-mécanique qui comprend :
un diaphragme (114, 214, 314, 414) et une électrode fixe (112, 212, 312, 412) qui est disposée de façon à s'opposer au diaphragme (114, 214, 314, 414) avec un espace (Gp) entre ceux-ci, et qui forme un condensateur avec le diaphragme (114, 214, 314, 414).

9. Procédé pour fabriquer un substrat de montage de dispositif de conversion électro-acoustique (12, 22, 32, 42) sur lequel est monté un dispositif de conversion électro-acoustique (11, 21, 31, 41) qui convertit un son d'entrée en un signal électrique, comprenant :
une première étape pour préparer un substrat (12', 22', 32a, 32b, 42a, 42b) qui est muni d'une ouverture (121, 221, 321, 421) formée à travers une surface de montage (12a, 22a, 32d, 42d) du substrat (12', 22', 32a, 32b, 42a, 42b) et recouverte par le dispositif de conversion électro-acoustique (11, 21, 31, 41), et d'un espace intra-substrat (122, 222, 322, 422) relié à l'ouverture (121, 221, 321, 421) ;
**caractérisé par** :
une deuxième étape pour appliquer un processus de placage de métal à une surface de paroi qui forme l'espace intra-substrat (122, 222, 322, 422) ; et
une troisième étape pour former un motif de câblage sur une surface extérieure de substrat par réalisation d'un processus de gravure après le processus de placage.

10. Procédé pour fabriquer un substrat de montage de dispositif de conversion électro-acoustique (12, 22, 32, 42) selon la revendication 9, comprenant de plus :
une quatrième étape pour fixer un autre substrat (32c, 42c) à une surface arrière opposée à une surface du substrat (12', 22', 32a, 32b, 42a, 42b), sur laquelle le motif de câblage est formé au cours du troisième processus, à travers lequel est formée l'ouverture (121, 221, 321, 421) ;
une cinquième étape pour monter un capot de protection (307, 408) afin de recouvrir la totalité de la surface du substrat (12', 22', 32a, 32b, 42a, 42b), sur laquelle le motif de câblage est formé au cours du troisième processus, à travers lequel est formée l'ouverture (121, 221, 321, 421) ;
une sixième étape pour former un trou traversant (308, 409) pour un câblage traversant (309, 410) à travers l'autre substrat (32c, 42c) ;
une septième étape pour appliquer un processus de placage au trou traversant (308, 409) pour le câblage traversant (309, 410) qui est formé au cours de la sixième étape après l'achèvement de la quatrième étape, de la cinquième étape et de la sixième étape, qui sont effectuées dans un ordre aléatoire ;
une,huitième étape pour former un motif de câblage sur l'autre substrat (32c 42c) à l'aide d'un processus de gravure après que la septième étape a été achevée ; et
une neuvième étape pour séparer le capot de protection (307, 408) après que le motif de câblage a été formé sur l'autre substrat (32c, 42c).

11. Procédé pour fabriquer une unité de microphone (1, 2, 3, 4) , comprenant :
une étape pour fabriquer un substrat de montage de dispositif de conversion électro-acoustique (12, 22, 32, 42) à l'aide d'un procédé de fabrication selon la revendication 9 ou 10 ;
une étape pour monter le dispositif de conversion électro-acoustique (11, 21, 31, 41) sur le substrat de montage de dispositif de conversion électro-acoustique (12, 22, 32, 42) de façon à recouvrir l'ouverture (121, 221, 321, 421) ; et
une étape pour recouvrir avec une partie de couverture (13, 23, 33, 43) le substrat de montage de dispositif de conversion électro-acoustique (12, 22, 32, 42) afin de recouvrir le dispositif de conversion électro-acoustique (11, 21, 31, 41).
